# EUROPÄISCHE PATENTSCHRIFT

(11) **EP 0 378 112 B1**
(45) Veröffentlichungstag und Bekanntmachung des Hinweises auf die Patenterteilung: **16.10.1996**
(21) Anmeldenummer: 90100167.7
(22) Anmeldetag: 04.01.1990
(51) Int. Cl.: G02B 6/42, H01L 31/108, H01L 31/07, G02B 6/12, H01L 27/00

(54) **Anordnung zum optischen Koppeln eines optischen Wellenleiters um eine Photodiode auf einem Substrat aus Silizium**
Arrangemet for optical coupling between an optical waveguide and a photodiode on a substrate of silicon
Dispositif pour couplage optique d'un guide d'ondes et d'une photodiode sur un substrat en silicium

(30) Priorität: 09.01.1989 DE 3900422
(43) Veröffentlichungstag der Anmeldung: 18.07.1990
(73) Patentinhaber: SIEMENS AKTIENGESELLSCHAFT, 80333 München (DE)
(72) Erfinder: Stein, Karl-Ulrich, Dr., D-8025 Unterhaching (DE)

(56) Entgegenhaltungen:
- EP-A- 0 226 296
- EP-A- 0 281 989
- US-A- 4 496 964
- OPTICAL ENGINEERING, Band 27, Nr. 6, Juni 1988, Seiten 503-506; D.R. LARSON et al.: "Fast optical detector deposited on dieletric channel waveguides"
- ELECTRONIC LETTERS, Band 23, Nr. 1, 2. Januar 1987, Seiten 2-4; C. BORNHOLDT et al.: "Waveguide-integrated pin photodiode on InP"
- JOURNAL OF LIGHTWAVE TECHNOLOGY, Band 6, Nr. 12, Dezember 1988, Seiten 1854- 1860; M. McWRIGHT HOWERTON et al.: "A thin-film waveguide photodetector using hydrogenated amorphous silicon"
- JAPANESE JOURNAL OF APPLIED PHYSICS; SUPPLEMENTS (18TH INT. CONF. ON SOLID STATE DEVICES AND MATERIALS, Tokyo, 1986), 20th - 22nd August 1986, Seiten 513- 516; H.-J. PARK et al.: "A high performance thin film platinum Schottky-barrier IR detector"
- IEEE ELECTRON DEVICE LETTERS, Band 9, Nr. 9, September 1988, Seiten 436-438; J. M. KURIANSKI et al.: "Novel 896-element infrared Schottky detector line array"
- PATENT ABSTRACTS OF JAPAN, Band 8, Nr. 264 (E-282)[1701], 4. Dezember 1984; & JP-A-59 135 779

## Beschreibung

Einkristallines Silizium bietet als Substrat für die integrierte Optik und integrierte Optoelektronik besondere Vorteile aufgrund seiner hochentwickelten Prozeßtechniken und geringen Kosten. Dies gilt insbesondere auch für den Wellenlängenbereich um 1,3 µm und 1,6 µm, der auch SWIR-Bereich (SWIR steht für Short Wave Infra-Red) genannt wird und in dem Silizium nur wenig absorbiert.

Für die eingesetzte Lichtwellenleitertechnik im SWIR-Bereich werden heute ausschließlich Elemente auf der Basis Gallium-Arsenid, Indium-Phosphid oder Germanium verwendet. Dies gilt allgemein auch für die Entwicklungen auf dem Gebiet der integrierten Optoelektronik.

Auf Silizium können sowohl integrierte elektrische als auch integrierte optische Schaltungen realisiert werden.

In Entwicklung befinden sich Wellenleiterdioden mit Heteroepitaxieschichten, insbesondere mit dem System GeₓSi₁₋ₓ/Si (siehe dazu IEEE Electronic Device Letters, Vol. EDL-7, No. 5, S. 330-332).

Flächendioden für SWIR und insbesondere Long-WIR (Long-WIR steht für Long Wave Infra-Red) werden seit geraumer Zeit auf der Basis von PtSi-, Pd₂Si- und IrSi-Schottky-Kontakten, insbesondere in gekühlten Charge-Coupled-Devices für die IR-Bildtechnik entwickelt und angewandt (siehe dazu IEEE Transactions on Electron Devices ED-32, 1564-1573 (1985), IEEE Transactions on Electron Devices ED-31, 968-970 (1984) oder IEEE Electron Device Letters 9, 100 - 102 (1988).

In der deutschen Patentanmeldung DE-A-38 33 311 ist in Anlehnung an die integrierten Photodetektor-Arrays mit Charge-Coupled-Devices eine Realisierung für eine elektrische und optische Schaltung vorgeschlagen, bei der integrierte Metall-Halbleiter-Dioden mit Platin-Silizid-Schottky-Barrieren verwendet sind. Aus dieser Patentanmeldung geht nicht hervor, wie Photodioden und optische Wellenleiter optisch miteinander zu koppeln sind, damit eine optisch-elektrische Wandlung durchgeführt werden kann.

In der EP 0 281 989 A1 ist eine Wellenleiter-Fotodiode-Kombination auf einem GaAs-Substrat beschrieben. Der Wellenleiter besteht aus einer für die Wellenführung vorgesehenen Schicht aus ZnO zwischen Schichten aus SiO₂. Im Bereich der Fotodiode befindet sich lateral zum Wellenleiter je ein Schottky-Übergang zwischen einer metallischen Schicht und dem Halbleitermaterial des Substrates. In der Veröffentlichung von M. Mc Wright Howerton et al. in J. Lightwave Technol. 6, 1854 bis 1860 (1988) ist eine Wellenleiter-Fotodiode-Kombination auf einem Quarz-Substrat beschrieben, bei der ein streifenförmiger Wellenleiter aus Glas benachbart zu einer Schottky-Diode aus einer an amorphes Silizium angrenzenden Chromschicht angeordnet ist. Diese Fotodiode befindet sich auf der dem Substrat abgewandten Seite des Wellenleiters und ist auf der Oberseite mit einer weiteren Elektrode aus Aluminium versehen.

Aufgabe der Erfindung ist es, eine verbesserte Wellenleiter-Fotodiode-Kombination anzugeben, die auf Silizium integriert in konventioneller IC-Technologie einfach hergestellt werden kann.

Diese Aufgabe wird durch die Wellenleiter-Fotodiode-Kombination mit den Merkmalen des Anspruchs 1 gelöst. Weitere Ausgestaltungen ergeben sich aus den abhängigen Ansprüchen.

Der im folgenden vorkommende Begriff "Leckwellenkopplung" bedeutet, daß die wellenleitende Kernschicht des optischen Wellenleiters und die Metallschicht der Diode parallel zueinander sind und sich überlappen und daß Maßnahmen getroffen sind, die bewirken, daß in dem Überlappungsbereich die im Wellenleiter geführte optische Welle nach außen leckt und in die absorbierende Metallsilizidschicht gelangt. Der Bereich, in dem die geführte optische Welle aus dem Wellenleiter leckt und in die Silizidschicht übertritt, ist im folgenden als Bereich der Leckwellenkopplung bezeichnet.

Zur Erzielung eines hohen Wirkungsgrades der Schottky-Barriere-Dioden soll einerseits die Schottky-Kontaktschicht so dick sein, daß sie gut absorbiert, andererseits so dünn sein, daß die entstehenden Ladungsträgerpaare in die Sperrschicht der Diode gelangen.

Der Wellenleiter kann aus einer wellenleitenden Kernschicht und einer zwischen dieser Kernschicht und dem Substrat aus Silizium angeordneten Mantelschicht bestehen, wobei die Kernschicht Si ist und für die Mantelschicht beispielsweise SiO₂ als Material geeignet ist. Die Kernschicht kann auch zwischen zwei Mantelschichten angeordnet sein.

Der Wellenleiter kann auch eine unmittelbar auf das Substrat aus Silizium aufgebrachte wellenleitende Kernschicht aufweisen. In diesem Fall muß die Kernschicht aus einem Material bestehen, das bezogen auf die in der Kernschicht geführte und im Silizium ausbreitungsfähige optische Welle eine höhere Brechzahl als das Silizium des Substrats aufweist, so daß das Substrat als ein Mantel des Wellenleiters fungiert. Dies kann erreicht werden, wenn die Kernschicht aus niedrig dotiertem und das Substrat aus hoch dotiertem Silizium besteht.

Die metallisch leitende Schottky-Kontaktschicht besteht vorzugsweise aus einem Metallsilizid, vorzugsweise aus PtSi, Pd₂Si, NiSi₂, IrSi oder PtIrSi.

Der Wellenleiter und/oder die Diode können auch aus amorphem Silizium bestehen, das mit Wasserstoff dotiert sein kann. Gemäß einer bevorzugten Ausgestaltung besteht die wellenleitende Kernschicht aus diesem Material, und die Diode ist auf dieser Schicht ausgebildet, wobei die Schottky-Kontaktschicht gleich auf dieser Kernschicht integriert ist auf der vom Substrat abgekehrten Seite dieser Schicht. Die Kernschicht und die Schottky-Kontaktschicht grenzen im Bereich der Leckwellenkopplung unmittelbar aneinander.

Die Schottky-Kontaktschicht kann einen zusammenhängenden flächenhaften Bereich bilden. In diesem Fall sind die Anschlüsse der Diode mit der Schottky-Kontaktschicht und mit dem an diese Schicht angrenzenden Silizium zu verbinden, wie es bei vertikalen Dioden üblicherweise der Fall ist. Es lassen sich erfindungsgemäß auch Photodioden mit Schottky-Kontaktschichten realisieren, die ähnlich wie die bekannten koplanaren Metall-Halbleiter-Metall-Strukturen auf InGa aufgebaut sind (siehe beispielsweise IEEE Electron Device Letters, Vol. 9, No. 10, Okt. 1988, S. 515-517), wenn eine Schottky-Kontaktschicht verwendet wird, die in voneinander getrennte Schottky-Kontakt-Teilschichten unterteilt ist, wobei wenigstens eine Teilschicht mit einem Anschluß und wenigstens eine getrennte andere Teilschicht mit dem anderen Anschluß der Diode verbunden ist.

Der besondere Vorteil einer erfindungsgemäßen koplanaren Metall-Halbleiter-Metall-Photodiodenstruktur mit Schottky-Kontaktschicht besteht darin, daß sie in einer noch wesentlich einfacheren Technologie hergestellt werden kann als übliche vertikale Diodenstrukturen, bei denen die Schottky-Kontakt-schicht und das daran angrenzende Silizium zu kontaktieren sind.

Vorteilhafterweise besteht für die Schottky-Kontakt-Teilschichten eine Freiheit der Gestaltung und Anordnung, insbesondere in bezug auf die Ausbreitungsrichtung der im Wellenleiter geführten optischen Welle. Sie können beispielsweise als längs und quer zur genannten Ausbreitungsrichtung angeordnete Elektrodenfinger ausgebildet sein, wobei eine Anordnung quer zum Wellenleiter vorteilhaft ist, da dabei die parasitären Längswiderstände der Schottky-Kontaktschicht gering gehalten werden können. Vorteilhaft ist es auch, das außerhalb des Wellenleiters befindliche metallisch leitende Material der Schottky-Kontaktschicht, beispielsweise Metallsilizid, durch eine Metallschicht, beispielsweise eine Aluminiumschicht, zu verstärken, die auch zum Anschließen verwendet werden kann.

Durch eine feine Gestaltung der Schottky-Kontakt-Teilschichten, beispielsweise in Form von feinen Elektrodenfingern, ist mit koplanaren Metall-Halbleiter-Metall-Diodenstrukturen im Vergleich zu vertikalen Dioden eine höhere Geschwindigkeit erzielbar, da die parasitären Kapazitäten geringer gehalten werden können, als bei vertikalen Dioden (siehe dazu IEEE Electron Device Letters, Vol. 9, No. 10, Okt. 1988, S. 527-529).

Bei Ausbildung der Schottky-Kontakt-Teilschichten in Form von quer zur Ausbreitungsrichtung der im Wellenleiter geführten optischen Welle liegenden Fingern kann die Fingerperiode an die im Wellenleiter vorliegenden Wellenlängen im Bereich unter 0,5 µm angepaßt werden. Damit kann einerseits die Absorption erhöht bzw. eine wellenlängenselektive Absorption erzeugt werden. Darüber hinaus kann die Unterteilung der Schottky-Kontaktschicht in getrennte Schottky-Kontakt-Teilschichten dazu verwendet werden, optische Gitterstrukturen unter dem Wellen leiter zu erzeugen, z.B. um Wellenleiterfilter darzustellen.

Bei den koplanaren Metall-Halbleiter-Metall-Photodioden ist generell während des Betriebs von zwei mit verschiedenen Anschlüssen der Diode verbundenen Schottky-Kontakt-Teilschichten in der Regel nur eine Teilschicht eine Elektrode, die den lichtinduzierten Photostrom erzeugende Ladungsträger emittiert. Beispielsweise wird der Photostrom im Falle eines n-dotierten oder p-dotierten Substrats durch eine emittierende Elektrode in Form von Elektronen bzw. Löchern emittiert, während eine nicht emittierende Elektrode im wesentlichen keine Löcher bzw. Elektronen abgibt, die zum Photostrom beitragen.

Man kann den Photostrom dadurch erhöhen, daß im Bereich der Leckwellenkopplung die mit einem Anschluß der Diode verbundenen Schottky-Kontakt-Teilschichten im Vergleich zu den mit dem anderen Anschluß der Diode verbundenen Schottky-Kontakt-Teilschichten flächenmäßig größer ausgebildet sind, vorzugsweise zu Lasten der letztgenannten Teilschichten. Die Diode ist dann lediglich so zu betreiben, daß die im Bereich der Leckwellenkopplung größer ausgebildeten Schottky-Kontakt-Teilschichten als emittierende Elektroden wirken.

Ordnet man im Bereich der Leckwellenkopplung nur ein oder mehrere mit einem Anschluß der Diode verbundene Schottky-Kontakt-Teilschichten und alle mit dem anderen Anschluß der Diode verbundene Schottky-Kontakt-Teilschichten außerhalb des Bereichs der Leckwellenkopplung an, kann aurch geeigneten Betrieb der Diode erreicht werden, daß im Bereich der Leckwellenkopplung nur emittierende und keine nichtemittierenden Elektroden angeordnet sind. Dies trägt zu einem hohen Photostrom bei.

Man kann den Photostrom auch dadurch erhöhen , daß man die unterschiedlichen Ladungsträger beider Elektroden durch Einbringen in die Raumladungszone zur jeweiligen Gegenelektrode befördert.

Man erreicht damit, daß bei den koplanaren Metall-Halbleiter-Metall-Photodioden generell sowohl die mit einem Anschluß als auch die mit dem anderen Anschluß der Diode verbundene Schottky-Kontakt-Teilschichten als emittierende Elektroden genutzt werden und zum Photostrom beitragen. Dazu werden die Abmessungen der Schottky-Kontakt-Teilschichten, die Dotierung des Halbleiters und die Betriebsspannung derart gewählt, daß eine mit einem Anschluß der Diode verbundene Schottky-Kontakt-Teilschicht eine Raumladungszone im angrenzenden Silizium oder anderen Halbleitermaterial erzeugt, die sich bis zu oder unter eine benachbarte, mit dem anderen Anschluß der Diode verbundene Schottky-Kontakt-Teilschicht ausdehnt, und daß das metallisch leitende Material der Schottky-Kontakt-Teilschichten so gewählt wird, daß in der mit dem einen Anschluß der Diode verbundenen Schottky-Kontakt-Teilschicht die Barrierespannung für Elektronen oder Löcher ungefähr gleich ist der Barrierespannung für Löcher bzw. Elektronen in der benachbarten, mit dem anderen Anschluß der Diode verbundenen Schottky-Kontakt-Teilschicht.

Wenn diese Barrierespannungen betragsmäßig kleiner als das durch die Wellenlänge der im Wellenleiter geführten optischen Welle bestimmte Lichtquant sind, emittiert jede Teilschicht entweder Elektronen oder Löcher.

Die Bedingung der etwa gleichen Barrierespannungen für Elektronen und Löcher läßt sich in der Regel durch Verwendung eines einzigen Materials für die Schottky-Kontakt-Schicht nicht erfüllen. Sie kann erfüllt werden, wenn eine mit einem Anschluß und eine mit dem anderen Anschluß der Diode verbundene Schottky-Kontakt-Teilschicht aus verschiedenen metallisch leitenden Materialien bestehen.

Eine erfindungsgemäße Anordnung kann vorteilhafterweise dahingehend verbessert werden, daß sie Verstärkereigenschaften aufweist. Bei einer ersten derartigen vorteilhaften Ausgestaltung ist der Rand der Schottky-Kontaktschicht mit einem Guardring versehen. Dieser Ring hat die Aufgabe, besonders hohe Feldstärken, die lokal am Rand der Schottky-Kontakt-schicht auftreten können, zu verringern. Die Dotierung des an diese Schicht angrenzenden Siliziums, die Dotierprofile und die Betriebsspannung werden so gewählt, daß eine Ladungsträgervervielfachung auftritt, die eine gewünschte Stromverstärkung erbringt. In diesem Fall ist die Schottky-Barriere-Photodiode als Avalanche-Photodiode gestaltet und betrieben. Eine derartige Photodiode mit einer Schottky-Kontaktschicht aus Platinsilizid ist für sich aus S. M. SZE, "Physics of Semiconductor Devices", John Wiley & Sons, Inc. (1969) S. 681 bekannt. Für eine derartige Photodiode ist n-dotiertes Silizium vorzuziehen, da die Ionisationsrate größer als bei p-dotiertem Silizium ist.

Bei den erfindungsgemäßen Anordnungen wird im Falle von n-dotiertem Silizium ausgenutzt, daß durch Lichtquanten aus einer metallisch leitenden Schottky-Kontaktschicht Elektronen in das Leitungsband des angrenzenden Halbleiters gebracht werden oder/und daß Elektronen aus dem Halbleiter vom Bereich des Bandabstandes zwischen dessen Valenz- und Leitungsband in eine metallisch leitende Schottky-Kontaktschicht gebracht und dadurch Löcher im Halbleiter erzeugt werden. Für p-dotiertes Silizium gilt sinngemäß das gleiche.

Der besondere Vorteil der erfindungsgemäßen Anordnung, insbesondere in den vorstehend beschriebenen Ausgestaltungen, besteht darin, daß die Anordnung in konventioneller IC-Technologie hergestellt und mit integrierten Schaltungen auf demselben Chip kombiniert werden kann und sie gleichzeitig ein Anpassen der Eigenschaften der Photodiode an die Anforderungen erlaubt. Darüber hinaus erlaubt Si als Substratmaterial die Ausnutzung des anisotropen Ätzens als mikromechanische Bearbeitung , um z.B. die Ankopplung und Montage der Glasfaser oder einer Linse an den Wellenleiter darzustellen.

Die Erfindung wird anhand der Figuren in der folgenden Beschreibung beispielhaft näher erläutert. Von den Figuren zeigen:
- Figur 1: einen Längsschnitt durch ein Ausführungsbeispiel einer erfindungsgemäßen Kombination,
- Figur 2: einen entsprechenden Schnitt durch ein anderes Ausführungsbeispiel,
- Figur 3: eine Draufsicht auf ein Ausführungsbeispiel der erfindungsgemäßen Anordnung, bei welcher die Metallsilizidschicht in voneinander getrennte Teilbereiche unterteilt ist, die mit verschiedenen Anschlüssen der Diode verbunden ist,
- Figur 4: einen längs der Linie IV - IV in Figur 3 geführten Schnitt durch dieses Ausführungsbeipiel,
- Figuren 5 und 6: Draufsichten auf andere Ausführungsbeispiele einer erfindungsgemäßen Vorrichtung mit in voneinander getrennte Teilbereiche unterteilter Metallsilizidschicht,

In allen Ausführungsbeispielen ist das Substrat mit 1, der optische Wellenleiter mit 2, die Diode mit 3 und die im Wellenleiter 2 geführte optische Welle mit 4 bezeichnet.

Das Bezugszeichen 20 bezeichnet die wellenleitende Kernschicht 20 des Wellenleiters 2, in der die optische Welle 4 im wesentlichen geführt wird. Mit 21 ist eine zwischen dem Substrat 1 und der Kernschicht 20 angeordnete Mantelschicht des Wellenleiters 2 bezeichnet. 22 bezeichnet eine auf der vom Substrat 1 abgekehrten Seite der Kernschicht 20 des Wellenleiters 2 angeordnete Mantelschicht dieses Wellenleiters 2.

Die Schottky-Barriere-Diode ist in den Figuren mit 3 bezeichnet. Ihre Schottky-Kontaktschicht ist mit dem Bezugszeichen 30 versehen. Die beiden Anschlüsse der Diode 3 sind mit 31 und 32 bezeichnet. Mit 36 ist eine Kontaktschicht aus Metall bezeichnet, welche die Schottky-Kontaktschicht 30 mit dem Anschluß 32 der Diode verbindet. Eine Kontaktschicht 35 aus Metall verbindet die Schottky-Kontaktschicht 30 oder an diese Schottky-Kontaktschicht 30 grenzendes Silizium mit dem Anschluß 31 der Diode 3.

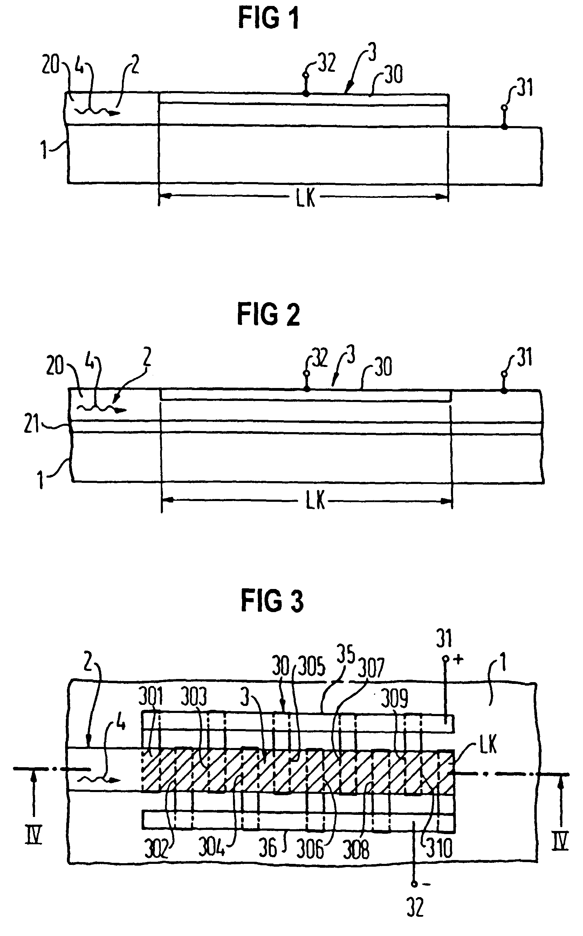

Der Bereich der Leckwellenkopplung ist in den Figuren mit LK bezeichnet und entspricht im wesentlichen dem in der Figur 3 schräg schraffierten Bereich einer Überlappung zwischen der Kernschicht 20 des Wellenleiters 2 und der Schottky-Kontaktschicht 30.

In allen dargestellten Ausführungsbeispielen besteht der Wellenleiter 2 aus einem streifenförmigen Wellenleiter, in dessen Längsrichtung die optische Welle 4 geführt wird. Beispielsweise besteht die Mantelschicht 21 aus SiO₂, die Schottky-Kontaktschicht aus PtSi und das Substrat aus p-dotiertem Silizium von etwa 30 Ohm.cm.

Zum Abstimmen der Eigenschaften der Anordnung wird die Länge des Bereichs LK der Leckwellenkopplung einerseits und die Dicke der Metallsilizidschicht 30 andererseits so gewählt, daß die im Wellenleiter 2 befindliche optische Welle weitgehend absorbiert und die Reflexion gering gehalten wird. Durch eine geringe Breite der Anordnung einschließlich der Kontaktschicht 36 kann ihre Kapazität gering gehalten werden.

Auf demselben Substrat 1 können in einer geeigneten Siliziumtechnologie ein Vorverstärker bzw. Impedanzwandler für die Photodiode 3 und weitere Elektronikeinheiten integriert werden, wie es in der genannten älteren Patentanmeldung DE-A-38 33 311 vorgeschlagen ist.

Bei dem Ausführungsbeispiel nach Figur 1 besteht das Substrat 1 aus hoch p-dotiertem Silizium, die wellenleitende Kernschicht 20 ist unmittelbar auf das Substrat 1 aufgebracht und besteht aus niedrig p-dotiertem Silizium, und die aus PtSi, d.h. aus Platinsilizio, bestehende Schottky-Kontaktschicht 30 ist unmittelbar auf der Kernschicht angeordnet.

Das Ausführungsbeispiel der Figur 2 unterscheidet sich vom Beispiel der Figur 1 dadurch, daß die wellenleitende Kernschicht 20 aus mit Wasserstoff dotiertem amorphem Silizium besteht und durch eine Mantelschicht aus SiO₂ vom Substrat 1 aus Silizium getrennt ist, wobei wie beim Beispiel nach Figur 1 die aus PtSi bestehende Schottky-Kontaktschicht 30 unmittelbar auf der Kernschicht 20 angeordnet ist.

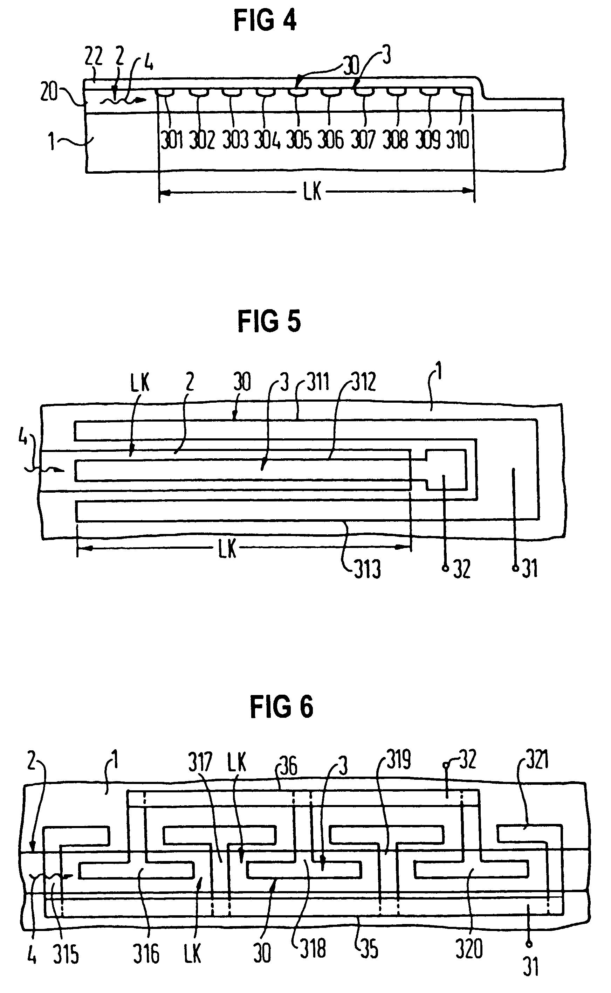

Das Ausführungsbeispiel nach den Figuren 3 und 4 unterscheidet sich von den bisher beschriebenen Ausführungsbeispielen im wesentlichen dadurch, daß die Schottky-Kontaktschicht 30 im Bereich LK der Leckwellenkopplung in eine in Ausbreitungsrichtung der im Wellenleiter geführten optischen Welle 4 sich erstreckende Reihe von hintereinander angeordneten und quer zu dieser Ausbreitungsrichtung sich erstreckenden Schottky-Kontakt-Teilschichten in Form von Elektrodenfingern 301 bis 310 unterteilt ist. Die Elektrodenfinger 301, 303, 305, 307 und 309 sind außerhalb des Bereichs LK der Leckwellenkopplung durch eine metallische Kontaktschicht 35 miteinander verbunden, die mit einem Anschluß 31 der Diode verbunden ist. Die Elektrodenfinger 302, 304, 306, 308 und 310 sind außerhalb des Bereichs LK der Leckwellenkopplung durch eine metallische Kontaktschicht 36 miteinander verbunden, die mit dem zweiten Anschluß 32 der Diode 3 verbunden ist.

Das Ausführungsbeispiel nach Figur 4 entspricht dem Ausführungsbeispiel nach Figur 1 und unterscheidet sich von diesem letztgenannten Beispiel durch die in die Elektrodenfinger 301 bis 310 unterteilte Schottky-Kontaktschicht 30 und eine auf die aus niedrig p-dotiertem Silizium bestehende Kernschicht 20 aufgebrachte Mantelschicht 22 aus beispielsweise SiO₂.

Beim Ausführungsbeispiel nach Figur 5 ist die Schottky-Kontaktschicht in drei Schottky-Kontakt-Teilschichten in Form von Elektrodenfingern 311, 312, 313 unterteilt, die in Ausbreitungsrichtung der im Wellenleiter 2 geführten optischen Welle 4 verlaufen. Im Bereich LK der Leckwellenkopplung ist nur der mittlere Elektrodenfinger 312 angeordnet. Die Elektrodenfinger 311 und 313 befinden sich außerhalb des Bereichs LK der Leckwellenkopplung. Der Elektrodenfinger 312 ist mit dem Anschluß 32 und die Elektrodenfinger 311 und 313 mit dem Anschluß 31 der Diode 3 verbunden. Die Diode 3 wird so betrieben, daß der Elektrodenfinger 312 als emittierende Elektrode wirkt.

Das Beispiel nach Figur 6 unterscheidet sich von den Beispielen nach den Figuren 3 bis 5 lediglich dadurch, daß anstelle der Elektrodenfinger 301 bis 313 anders geformte Elektrodenfinger 315 bis 321 verwendet sind. Im Bereich LK der Leckwellenkopplung sind die Elektrodenfinger 316, 318 und 320 gegenüber den Elektrodenfingern 315, 315, 319 und 321 flächenmäßig stark vergrößert. Dies wird durch eine T-förmige Ausbildung der Elektrodenfinger 315 bis 321 erreicht, wobei sich im Falle der Elektrodenfinger 316, 318 und 320 der in Ausbreitungsrichtung der optischen Welle 4 ausgerichtete waagerechte Schenkel des T im Bereich LK der Leckwellenkopplung befindet, während sich im Fall der Elektrodenfinger 315, 317, 319 und 321 nur der quer zur Ausbreitungsrichtung der optischen Welle 4 sich erstreckende vertikale Schenkel des T im Bereich LK der Leckwellenkopplung befindet. Beim Beispiel nach Figur 6 wird die Diode 3 so betrieben, daß die Elektrodenfinger 316, 318 und 320 emittierende Elektroden bilden. Die Elektrodenfinger sind so bemessen, daß während des Betriebs unter ihnen eine Raumladungszone im beispielsweise n-dotierten Silizium entsteht, die sich bis unter die mit dem anderen Anschluß 31 verbundenen Elektrodenfinger der Schottky-Kontaktschicht 30 erstreckt. Außerdem ist das Material der Elektrodenfinger so gewählt, daß ein Lichtquant der optischen Welle 4 aus den emittierenden Elektrodenfingern Elektronen emittiert und durch die anderen Elektrodenfinger Löcher induziert.

## Patentansprüche

1. Integrierte Wellenleiter-Fotodiode-Kombination auf einem Substrat (1) aus Silizium,
bei der der Wellenleiter (2) eine streifenförmige Kernschicht (20) zum Führen optischer Wellen (4) aufweist,
bei der diese Kernschicht (20) über dem Substrat (1) angeordnet ist,
bei der diese Kernschicht (20) Silizium ist,
bei der die Fotodiode (3) eine Schottky-Barriere-Diode ist und
bei der eine Kontaktschicht (30) aus metallisch leitendem Material auf der dem Substrat (1) abgewandten Seite unmittelbar an die Kernschicht (20) über deren gesamte Breite angrenzt,
wobei die Kernschicht (20) und diese Kontaktschicht (30) diese Schottky-Barriere-Diode bilden und wobei zwischen der Kontaktschicht (30) und der Kernschicht (20) Leckwellenkopplung besteht.

2. Wellenleiter-Fotodiode-Kombination nach Anspruch 1,
bei der die Kernschicht (20) und das Substrat (1) unmittelbar aneinandergrenzen und
bei der die Kernschicht (20) eine höhere Brechzahl als das Substrat (1) aufweist.

3. Wellenleiter-Fotodiode-Kombination nach Anspruch 1 oder 2, bei der die Kontaktschicht (30) IrSi, NiSi₂ oder PtIrSi ist.

4. Kombination nach einem der Ansprüche 1 bis 3,
bei der der Rand der Kontaktschicht (30) mit einem Guardring versehen ist.

5. Kombination nach einem der Ansprüche 1 bis 4,
bei der die Schottky-Kontaktschicht (30) in Teilschichten in Form von Elektrodenfingern (301 bis 310; 311, 312, 313; 315 bis 321) unterteilt ist, von denen ein erster Anteil (301, 303, 305, 307, 309; 311, 313; 315, 317, 319, 321) untereinander und mit einem ersten Anschluß (31) der Fotodiode (3) elektrisch leitend verbunden ist und von denen ein zweiter Anteil (302, 304, 306, 308, 310; 312; 316, 318, 320) untereinander und mit einem zweiten Anschluß (32) der Fotodiode (3) elektrisch leitend verbunden ist.

6. Kombination nach Anspruch 5,
bei der die Elektrodenfinger (301 bis 310; 315, 317, 319, 321) quer zur Längsrichtung des Wellenleiters (2) ausgerichtet sind und in der Längsrichtung des Wellenleiters (2) aufeinanderfolgend angeordnet und alternierend mit dem ersten Anschluß (31) oder mit dem zweiten Anschluß (32) der Fotodiode (3) elektrisch leitend verbunden sind.

7. Kombination nach Anspruch 5 oder 6,
bei der Elektrodenfinger (301 bis 310; 311, 312, 313; 315 bis 321) so bemessen sind, daß sie als optisches Gitter wirken.

8. Kombination nach Anspruch 5,
bei der die mit dem ersten Anschluß (31) der Fotodiode (3) elektrisch leitend verbundenen Elektrodenfinger (311, 313) außerhalb des Bereichs der Leckwellenkopplung (LK) angeordnet sind.

9. Kombination nach einem der Ansprüche 5 bis 8,
bei der die mit dem ersten Anschluß (31) und dem zweiten Anschluß (32) der Fotodiode (3) elektrisch leitend verbundenen Teilschichten aus verschiedenen metallisch leitenden Materialien bestehen.

## Claims

1. Integrated waveguide/photodiode combination on a substrate (1) made of silicon,
in which the waveguide (2) has a core layer (20) in the form of a strip for guiding optical waves (4),
in which this core layer (20) is arranged over the substrate (1),
in which this core layer (20) is silicon,
in which the photodiode (3) is a Schottky barrier diode, and
in which a contact layer (30) made of metallically conductive material directly adjoins the core layer (20) over the entire width of the latter on the side facing away from the substrate (1), the core layer (20) and this contact layer (30) forming the said Schottky barrier diode and leaky wave coupling existing between the contact layer (30) and the core layer (20).

2. Waveguide/photodiode combination according to Claim 1,
in which the core layer (20) and the substrate (1) directly adjoin one another, and
in which the core layer (20) has a higher refractive index than the substrate (1).

3. Waveguide/photodiode combination according to Claim 1 or 2,
in which the contact layer (30) is IrSi, NiSi₂ or PtIrSi.

4. Combination according to one of Claims 1 to 3,
in which the edge of the contact layer (30) is provided with a guard ring.

5. Combination according to one of Claims 1 to 4,
in which the Schottky contact layer (30) is subdivided into partial layers in the form of electrode fingers (301 to 310; 311, 312, 313; 315 to 321), a first group of which (301, 303, 305, 307, 309; 311, 313; 315, 317, 319, 321) are electrically conductively connected to one another and to a first connection (31) of the photodiode (3), and a second group of which (302, 304, 306, 308, 310; 312; 316, 318, 320) are electrically conductively connected to one another and to a second connection (32) of the photodiode (3).

6. Combination according to Claim 5,
in which the electrode fingers (301 to 310; 315, 317, 319, 321) are aligned transversely with respect to the longitudinal direction of the waveguide (2) and are arranged such that they follow one another in the longitudinal direction of the waveguide (2) and are electrically conductively connected alternately to the first connection (31) or to the second connection (32) of the photodiode (3).

7. Combination according to Claim 5 or 6,
in which the electrode fingers (301 to 310; 311, 312, 313; 315 to 321) are dimensioned in such a way that they act as an optical grating.

8. Combination according to Claim 5,
in which the electrode fingers (311, 313) which are electrically conductively connected to the first connection (31) of the photodiode (3) are arranged outside the region of leaky wave coupling (LK).

9. Combination according to one of Claims 5 to 8,
in which the partial layers which are electrically conductively connected to the first connection (31) and to the second connection (32) of the photodiode (3) are composed of different metallically conductive materials.

## Revendications

1. Combinaison intégrée d'un guide d'ondes et d'une photodiode sur un substrat (1) en silicium,
dans laquelle le guide d'ondes (2) comprend une couche noyau (20) en forme de bande pour conduire les ondes optiques (4),
dans laquelle cette couche noyau (20) est disposée au dessus du substrat (1),
dans laquelle cette couche noyau (20) est du silicium,
dans laquelle la photodiode (3) est une diode barrière Schottky et,
dans laquelle une couche de contact (30) composée d'un matériau métalloconducteur est directement adjacente à la couche noyau (20) sur toute sa largeur du côté opposé au substrat (1), la couche noyau (20) et cette couche de contact (30) formant cette diode barrière Schottky, et un couplage d'onde de fuite existant entre la couche de contact (30) et la couche noyau (20).

2. Combinaison d'un guide d'onde et d'une photodiode selon la revendication 1,
dans laquelle la couche noyau (20) et le substrat (1) sont directement adjacents et
dans laquelle la couche noyau (20) présente un indice de réfraction supérieur au substrat (1).

3. Combinaison d'un guide d'onde et d'une photodiode selon la revendication 1 ou 2,
dans laquelle la couche de contact (30) est de l'IrSi, du NiSi₂ ou du PtlrSi.

4. Combinaison selon l'une des revendications 1 à 3, dans laquelle le bord de la couche de contact (30) est pourvu d'un anneau de garde.

5. Combinaison selon l'une des revendications 1 à 4, dans laquelle la couche de contact Schottky (30) est divisée en couches partielles sous forme de doigts d'électrode (301 à 310; 311, 312, 313; 315 à 321), dont une première partie (301, 303, 305, 307, 309; 311, 313; 315, 317, 319, 321) sont reliés entre eux par électroconduction et par une première connexion (31) de la photodiode (3), et dont une seconde partie (302, 304, 306, 308, 310; 312; 316, 318, 320) est reliée entre eux par électroconduction et à une seconde connexion (32) de la photodiode (3).

6. Combinaison selon la revendication 5, dans laquelle les doigts d'électrode (301 à 310; 315, 317, 319, 321) sont orientés transversalement au sens longitudinal du guide d'ondes (2) et sont disposés successivement dans le sens longitudinal du guide d'ondes (2) et sont reliés en alternance par électroconduction à la première connexion (31) ou à la seconde connexion (32) de la photodiode (3).

7. Combinaison selon la revendication 5 ou 6,
dans laquelle des doigts d'électrode (301 à 310; 311, 312, 313; 315 à 321) sont dimensionnés de manière à fonctionner comme grille optique.

8. Combinaison selon la revendication 5,
dans laquelle les doigts d'électrode 311, 313 reliés par électroconduction à la première connexion (31) de la photodiode (3) sont disposés à l'extérieur de la zone du couplage d'onde de fuite (LK).

9. Combinaison selon l'une des revendications 5 à 8,
dans laquelle les couches partielles reliées par électroconduction à la première connexion (31) et à la seconde connexion (32) de la photodiode (3) sont constituées de différents matériaux métalloconducteurs.
